Europäisches Patentamt

European Patent Office

Office européen des brevets

(19)

(11) Publication number: **0 304 953**
**A2**

(12) **EUROPEAN PATENT APPLICATION**

(21) Application number: 88114030.5

(22) Date of filing: 26.08.88

(51) Int. Cl.4: **C01F 17/00 , C01G 3/02 , H01L 39/12 , C04B 35/50**

(30) Priority: 28.08.87 JP 213023/87

(43) Date of publication of application:
01.03.89 Bulletin 89/09

(84) Designated Contracting States:
BE DE FR GB IT NL SE

(71) Applicant: **MITSUBISHI KINZOKU KABUSHIKI KAISHA**
5-2, Otemachi 1-chome
Chiyoda-ku Tokyo 100(JP)

(72) Inventor: **Kimura, Etsuji**
1-25-7, Yutaka-cho
Kasukabe-shi Saitama-ken(JP)
Inventor: **Hasegawa, Nozomu**
2-410-2-202 Kitabukuro-cho
Omiya-shi Saitama-ken(JP)
Inventor: **Nishiyama, Yutaka**
2465-1 Naoshima-cho Kagawa-gun
Kagawa-ken(JP)

(74) Representative: **Strehl, Schübel-Hopf, Groening, Schulz**
Maximilianstrasse 54 Postfach 22 14 55
D-8000 München 22(DE)

(54) Process for preparing compound metal oxide powder.

(57) A process for preparing powder a compound oxide of a rare earth metal, an alkaline earth metal and copper of a specific composition is disclosed. The process comprises preparing an aqueous solution containing respective water soluble salts of a volatile acid and a rare earth metal, an alkaline earth metal and copper in the same content ratio as the content ratio of the metals in the object compound metal oxide, said solution optionally containing a volatile acid, adding at least one organic polybasic acid and at least one glycol which has a boiling point higher than water, heating the solution to expel the water, said volatile acid and the acid radical moiety of said organic polybasic acid, and burning the remaining composition containing glycol by means of a burner.

## Process for preparing compound metal oxide powder

### Field of the Invention

This invention relates to an improved process for preparing powder of compound oxides of a rare earth metal, an alkaline earth metal and copper of specific compositions, which have recently drawn attention as superconductor materials.

### Background of the Invention

As methods for preparing compound metal oxides, generally there have been known processes in which

(1) Oxides, carbonates or oxalates of the respective component metals are physically crushed and mixed in the state of powder, and the mixture is fired and pulverized;

(2) Water-soluble salts such as nitrates, chlorides, etc. of the respective component metals are dissolved in water to make a homogeneous solution, the metals are coprecipitated as insoluble hydroxides, carbonates or oxalates by addition of hydroxide ions, carbonate ions or oxalate ions, and the precipitate is collected and fired into a compound metal oxide, etc. And rather recently, a process in which

(3) From an organic solvent solution (strictly speaking, suspension) or organic compounds, especially alkoxides, of the component metals, compound hydroxide is obtained, and the resulting compound hydroxide is fired to give a compound metal oxide, has been developed.

In process (1), the powders are mixed and fired. Therefore, the reaction proceeds from the boundaries of the powder particles and there remain some unreacted portions. Thus the resulting product is inevitably not completely homogeneous with local irregularity.

Process (2) is disadvantageous in that the condition of precipitation differs from metal to metal, and, therefore, compound metal oxides having the same content ratio of metals as that in the solution are not always produced.

Process (3) also has some disadvantages. There are few copper compounds which easily dissolve in organic solvents; organic compounds derived from the starting materials remain in the resulting hydroxide, which adversely affects firing; the hydroxide requires firing at a temperature of 800° C or higher and this induces the grain growth, etc. Thus, a pretreatment such as calcining to remove the residual organic substances is required prior to substantial firing. This invention relates to an improvement of process (2).

### Summary of the Invention

This invention provides a process for preparing a compound oxide powder of a rare earth metal, an alkaline earth metal and copper of a specific composition comprising preparing an aqueous solution containing respective water soluble salts of a volatile acid and a rare earth metal, an alkaline earth metal and copper in the same content ratio as the content ratio of the metals in the object compound metal oxide, said solution optionally containing a volatile acid, adding at least one organic polybasic acid and at least one glycol which has a boiling point higher than water, heating the solution to expel the water, the acid radical moiety of said salts and organic polybasic acid, burning the remaining composition containing glycol by means of a burner.

In the present invention, the term "rare earth metal" means Sc, Y, La, Ce, Pr, Nd, Pm, Sm, Eu, Gd, Tb, Dy, Ho, Er, Tm, Yb and Lu.

In the present invention, the term "alkaline earth metal" means Be, Mg, Ca, Sr and Ba.

In the process of the present invention, all the water-soluble salts of a volatile acid and a rare earth metal, an alkaline earth metal and copper can be used. Preferable are acetates, nitrates, chlorate, perchlorates, etc. Salts of non-volatile acids such as sulfuric acid cannot be used. The acid is limited to one whose acid radical moiety can be easily removed.

In the process of the present invention, any organic polybasic acid can be used so long as it is water-soluble. Typical examples are tribasic acids such as citric acid, iso-citric acid, aconitic acid, oxosuccninic acid, tricarbarylic acid, etc.; dibasic acids such as succinic acid, malic acid, malonic acid, glutaric acid, etc.

As a glycol, glycerine, ethylene glycol, propylene glycol, trimethylene glycol, diethylene glycol, triethylene glycol, etc. can be used.

Ordinary liquid fuel burners which are used for burning heavy oil or kerosene can be used in the process of the present invention. It is preferable to use a burner equipped with a double tube nozzle through the outer tube of which air is supplied.

Collection of the formed oxide from the aerosol resulting from burning can be easily effected by means of a hot cyclone, sintered filter, bag filter, etc.

The reaction mechanism of the process of the present invention, is not yet clearly understood. It is surmized that the polybasic acid used chelates (complexes) the metals, and the glycol combines with the resulting complex, which is made easily separable from water, and the complex burns itself to produce compound metal oxide directly.

The process of the present invention gives highly homogeneous compound metal oxides. Calcining of the hydroxide which is essential in conventional processes is not required.

Specific Description of the Invention

The present invention will now be explained by way of working examples.

Example 1

2.4g of copper oxide, 1. 1g of yttrium oxide and 4.0g of barium carbonate were dissolved in 100mℓ of a 1N nitric acid aqueous solution. To this solution, 10.9g of citric acid was added under stirring, and further 100mℓ of ethylene glycol was added. The mixture was allowed to stand for 30min, whereafter it was heated at 120°C over about 3 hours to expel the added acid, the acid radical moiety of the salt and water. The residual viscous liquid was burnt by means of a double tube nozzle oil burner and the aerosol formed was trapped by a suction bag filter and the compound metal oxide powder was collected.

The collected powder was pressed into a compact, which was sintered in air at 900°C. Chemical analysis revealed that the composition of this sinter was $YBa_2 Cu_3 O_{7-x}$, wherein x is a small fraction which represents deviation from stoichiometric relation but cannot be specified for the time being. Also X-ray diffraction analysis confirmed that this was not a mixture of a plurality of simple oxides.

This compound metal oxide powder was chilled, and its electric conductivity was measured. The electric resistance became zero at 90K.

Example 2

6g of copper oxide, 2.75g of yttrium oxide and 10g of barium carbonate were dissolved in 300mℓ of a 1N aqueous solution of nitric acid. To this solution were added 27.3g of citric acid under stirring and further 300mℓ of ethylene glycol was added. After use solution had been allowed to stand for 30 minutes, it was heated at 120°C over about 3 hours to expel the contained acid, the acid radical moiety of the salt and water. The residual viscous liquid was burnt by means of a double tube nozzle oil burner and the aerosol formed was trapped by a suction bag filter and the compound metal oxide powder was collected.

The collected powder was pressed into a compact and the compact was sintered in air at 900°C. Chemical analysis revealed that the composition of this sinter was $YBa_2 Cu_3 O_{7-x}$, wherein x is a small fraction which represents deviation from stoichiometric relation but cannot be specified for the time being. Also X-ray diffraction analysis confirmed that this was not a mixture of a plurality of simple oxides.

This compound metal oxide sinter was chilled, and its electric conductivity was measured. The electric resistance became zero at 90K.

Example 3

4.8g of copper oxide, 2.2g of yttrium oxide and 8g of barium carbonate were dissolved in 200mℓ of a 1N aqueous solution of nitric acid. To this solution were added 21g of citric acid under stirring and further 200mℓ of propylene glycol was added. After the solution had been allowed to stand for 30 minutes, it was heated at 120°C over about 3 hours to expel the contained acid, the acid radical moiety of the salt and water. The residual viscous liquid was burnt by means of a double tube nozzle oil burner and the aerosol formed was trapped by a suction bag filter and the compound metal oxide powder was collected.

The collected powder was pressed into a compact and the compact was sintered in air at 900°C. Chemical analysis revealed that the composition of this compact was $YBa_2 Cu_3 O_{7-x}$, wherein x is a small fraction which represents deviation from stoichiometric relation but cannot be specified for the time being. Also X-ray diffraction analysis confirmed that this was not a mixture of a plurality of simple oxides.

This compound metal oxide sinter was chilled, and its electric conductivity was measured. The electric resistance became zero at 90K.

Example 4

12g of copper oxide, 5.5g of yttrium oxide and 20g of barium carbonate were dissolved in 600mℓ of a 1N aqueous solution of nitric acid. To this solution were added 53g of aconitic acid under stirring and further in 600mℓ of glycerine was added. After the solution had been allowed to stand for 30 minutes, it was heated at 120°C over about 3 hours to expel the contained acid, the acid radical moiety of the salt and water. The residual viscous liquid was burnt by means of a double tube nozzle oil burner and the formed aerosol was trapped by a suction bag filter and the compound metal oxide powder was collected.

The collected powder was pressed into a compact and the compact was sintered in air at 900°C. Chemical analysis revealed that the composition of this sinter was $YBa_2 Cu_3 O_{7-x}$, wherein x is a small fraction which represents deviation from stoichiometric relation but cannot be specified for the time being. Also X-ray diffraction analysis confirmed that this was not a mixture of a plurality of simple oxides.

This compound metal oxide sinter was chilled, and its electric conductivity was measured. The electric resistance became zero at 90K.

Example 5

13.1g of copper oxide, 6.0g of yttrium oxide and 21.8g of barium carbonate were dissolved in 600mℓ of a 1N aqueous solution of nitric acid. To this solution were added 63g of malic acid under stirring and further 600mℓ of propylene glycol was added. After the solution had been allowed to stand for 30 minutes, it was heated at 120°C over about 3 hours to expel the contained acid, the acid radical moiety of the salt and water. The residual viscous liquid was burnt by means of a double tube nozzle oil burner and the aerosol formed was trapped by a suction bag filter and the compound metal oxide powder was collected.

The collected powder was pressed into a compact and the compact was sintered in air at 900°C. Chemical analysis revealed that the composition of this compact was $YBa_2 Cu_3 O_{7-x}$, wherein x is a small fraction which represents deviation from stoichiometric relation but cannot be specified for the time being. Also X-ray diffraction analysis confirmed that this was not a mixture of a plurality of simple oxides.

This compound metal oxide sinter was chilled, and its electric conductivity was measured. The electric resistance became zero at 90K.

Example 6

10.9g of copper oxide, 5.0g of yttrium oxide and 18.2g of barium carbonate were dissolved in 500mℓ of a 1N aqueous solution of nitric acid. To this solution were added 60g of glutaric acid under stirring and further 500mℓ of trimethylene glycol was added. After the solution had been allowed to stand for 30 minutes, it was heated at 120°C over about 3 hours to expel the contained acid, the acid radical moiety of the salt and water. The residual viscous liquid was burnt by means of a double tube nozzle oil burner and the aerosol formed was trapped by a suction bag filter and the compound metal oxide powder was collected.

The collected powder was pressed into a compact and the compact was sintered in air at 900°C. Chemical analysis revealed that the composition of this sinter was $YBa_2 Cu_3 O_{7-x}$, wherein x is a small fraction which represents deviation from stoichiometric relation but cannot be specified for the time being. Also X-ray diffraction analysis confirmed that this was not a mixture of a plurality of simple oxides.

This compound metal oxide sinter was chilled, and its electric conductivity was measured. The electric resistance became zero at 90K.

Example 7

17.5g of copper oxide, 8.0g of yttrium oxide and 29.1g of barium carbonate were dissolved in 750mℓ of a 1N aqueous solution of nitric acid. To this solution were added 83g of malic acid under stirring and further 750mℓ of glycerine was added. After the solution had been allowed to stand still for 30 minutes, it was heated at 120°C over about 3 hours to expel the contained acid, the acid radical moiety of the salt and water. The residual viscous liquid was burnt by means of a double tube nozzle oil burner and the formed aerosol was trapped by a suction bag filter and the compound metal oxide powder was collected.

The collected powder was pressed into a compact and the compact was sintered in air at 900°C. Chemical analysis revealed that the composition of this sinter was $YBa_2 Cu_3 O_{7-x}$, wherein x is a small fraction which represents deviation from stoichiometric relation but cannot be specified for the time being. Also X-ray diffraction analysis confirmed that this was not a mixture of a plurality of simple oxides.

This compound metal oxide sinter was chilled, and its electric conductivity was measured. The electric resistance became zero at 90K.

**Claims**

1. A process for preparing powder a compound oxide of a rare earth metal, an alkaline earth metal and copper of a specific composition comprising preparing an aqueous solution containing respective water soluble salts of a volatile acid and a rare earth metal, an alkaline earth metal and copper in the same content ratio as the content ratio of the metals in the object compound metal oxide, said solution optionally containing a volatile acid, adding at least one organic polybasic acid and at least one glycol which has a boiling point point higher than water, heating the solution to expel the water, said volatile acid and the acid radical moiety of said organic polybasic acid, and burning the remaining composition containing glycol by means of a burner.

2. The process for preparing a compound oxide of a rare earth metal, an alkaline earth metal and copper of a specific composition as rcited in Claim 1, wherein a salt of a volatile acid is selected from the group consisting of nitric acid, acetic acid and perchloric acid; a glycol is selected from the group consisting of glycerine, ethylene glycol, propylene glycol and trimethylene glycol; and an organic acid is selected from the group consisting of citric acid, aconitic acid, succinic acid, malic acid, malonic acid and glutaric acid.

3. The process for preparing a compound oxide of a rare earth metal, an alkaline earth metal and copper of a specific composition as rcited in Claim 2, wherein a salt of a volatile acid selected from the groups consisting of nitric acid and acetic acid; a glycol is selected from the group consisting of glycerine, ethylene glycol and propylene glycol; and an organic acid is selected from the group consisting of citric acid, succinic acid, malic acid and glutaric acid.

4. The process for preparing a compound oxide of a rare earth metal, an alkaline earth metal and copper of a specific composition as rcited in any of the preceding Claims, wherein a double tube nozzle fuel burner is used.